# EUROPEAN PATENT APPLICATION

(11) **EP 2 733 414 A2**
(43) Date of publication of application: **21.05.2014**
(21) Application number: 13005376.2
(22) Date of filing: 15.11.2013
(51) Int. Cl.: F21V 8/00, G02B 6/00

(54) **Control panel of an appliance**

(30) Priority: 20.11.2012 SI 201200350
(71) Applicant: GORENJE gospodinjski aparati, d.d., 3320 Velenje (SI)
(72) Inventor: Steblovnik, Konrad, 3327 Smartno Ob Paki (SI)
(74) Representative: Golmajer Zima, Marjanca

(57) **Abstract**

A control unit of an appliance comprising lightning information segments (2) for marking and illuminated capacitive switches (3) which can be integrated in a front panel (4) of an appliance or apparatus which can be a household appliance, a computer control system, a medical device or any other device or machine controlled by a human. The characteristic of the invention is an electrically conductive layer (6b) of the sensor of the capacitive switch (3) in the shape of a mesh covered by a protective layer (8) preferably of a white colour and fitting to the structure of the mesh, and on the protective layer (8) the light guide (14) is arranged which fills the cavity (15) and fits the protective layer (8) and thus the mesh-like electrically conductive layer (6b), with which the lower plane of the light guide (14) is formed in the sense of a plurality of lens-like projections (17), whereas the cavity (19) of the segments (2) is formed in a way that side planes (20) are slanted and matted for the light to reflect upwards, and the cavity (19) is at the same time filled with the light guide (14).

## Description

### Object of the Invention

The object of the invention is a control unit comprising lightning information segments for marking and illuminated capacitive switches that allow control. Such a unit is integrated in a front panel of an appliance or apparatus which can be a household appliance, a computer control system, a medical device or any other device or machine controlled by a human.

### Technical Problem

The technical problem solved by the present invention is integration of lightning information segments for marking and illuminated capacitive switches in one control panel that allows an intuitive and ergonomic use, wherein the best possible and the most uniform illumination of said elements of the control panel should be provided for without any light noise; the invention should further simultaneously provide for a less expensive assembly and production, and a smaller amount of integrated parts contributes to material savings and to a more reliable operation.

### Prior Art

The existing prior art does not offer a solution that would combine lightning information segments for marking and illuminated capacitive switches on one single control panel, only solutions for each element separately are known.

Application No. WO2007/138294 discloses a solution to lightning of lightning segments that make up a seven-segment display by way of side emitting LEDs, light guiding structures and light scattering means. The solution requires a transparent base substrate, on which side emitting LEDs are arranged, and a special reflective layer in the form of a special colour on the underside of the transparent base substrate. The use of the transparent base substrate and the application of a special colour increase the manufacturing costs of such a display.

Patent No. GB2459888 solves the technical problem of illumination of capacitive switches which is needed for a user to obtain feedback on ON/OFF and on the position of said switches. It has proved that due to a possible interference between an electrical field of a capacitive switch and a connected light source the latter must not be arranged on or in close proximity to the capacitive switch. Since a use of transparent capacitive switches and backlight illumination is an expensive and demanding solution, this invention suggests illumination by a light source and a light guide that guides the light from the light source to the surface of a capacitive switch. The light source and the capacitive switch are thus distant from each other. Due to a total reflection of the light in the light guide a further light scattering means is needed which is arranged underneath the light guide and both intercept the light and redirect it to a graphical layer, on which graphical symbols or icons for a capacitive key are arranged.

The solution from the above invention has several drawbacks. Prefabricated light guides are used, the dimensions of which must correspond to each individual segment and be provided with a cavity for a light source. The light guides are injection moulded or mechanically shaped, therefore adequate tools for injection moulding of plastics need to be manufactured in the first case and several treatment processes are needed in the second case. The assembly requires a special tool used for inserting the light guides into the cavities of a means for light separation of individual capacitive switches on a printed circuit board. This means a further work step and consequently a more expensive assembly procedure.

### Solution to the Technical Problem

The above-indicated technical problem is solved by a solution of the invention. On a single printed circuit board there are arranged segments that make up a seven-segment display of alphanumerical signs, and capacitive switches. Display segments are embodied to display numerical and sign information to a user of the appliance, whereas the capacitive switches are used to control the appliance (e. g. to enter commands and values to the control appliance which is per se not the object of the present invention).

Each segment is illuminated by a so-called side LED illuminating the segment from a side. The LED is arranged on a printed circuit board that forms a bottom limit of a segment cavity. The cavity is limited at its upper side by a graphic foil, through which the light from the LED is emitted and provides information for a user. As the LEDs of seven-segment displays are arranged on a small surface and close to one another, they are coated from sides by a light separation means in order to reduce penetration of the light into individual segments. The light separation means is integrated in a so-called support frame or is a part thereof. At one side, a plane of said means is formed at an angle and its surface is slightly matted, which allows good reflection and scattering of the light. At the other side, the light separation means is preferably formed in a way to cover the upper side of the LED, which prevents light losses. The upper surface of the printed circuit board under the LED is coated with a white layer in order to achieve better reflection of part of luminous flux. For an even better light scattering and a more uniform illumination of the segment the cavity may be filled with a special transparent agent from a heat or UV curable material that acts as a light guide. This material is poured into individual openings of the support frame, said openings representing at the same time also the openings of segment cavities and coincide with the arrangement of individual segments on the printed circuit board.

The capacitive switches are also illuminated by the side LEDs arranged on the printed circuit board. Said switches are embodied of electrically conductive surfaces on the upper surface of the printed circuit board, said surfaces having special mesh-shaped or raster-shaped cavities produced by a printed circuit board manufacturer. The surface of the capacitive switch is significantly larger compared to the surface of a display segment, which results in reduced illumination of the capacitive switch, and the illumination is even further reduced with the distance from the light source. This problem is solved by use of light guides. Said guides are poured by means of a special material into the openings formed in the support frame acting as a means for light separation of individual capacitive switches and set by way of temperature or UV light. Additionally, the upper surface of the printed circuit board or the mesh of the electrically conductive surface is provided with a light-reflective white layer, preferably a white colour that improves the reflection of the light.

The lower surface of the light guide with projections is formed as a cat's eye. It therefore scatters the light emitted by the LED well and fits the mesh structure or the cavities of the electrically conductive surface of the capacitive sensor on the upper surface of the printed circuit board. The electrically conductive surface of the capacitive sensor on the lower side and that of the planes of the light separation means at the sides function as a mould for pouring in the material for the formation of the light guide, which reduces the manufacturing costs.

The invention will be explained in more detail in the continuation by way of an embodiment and the enclosed figures, in which:

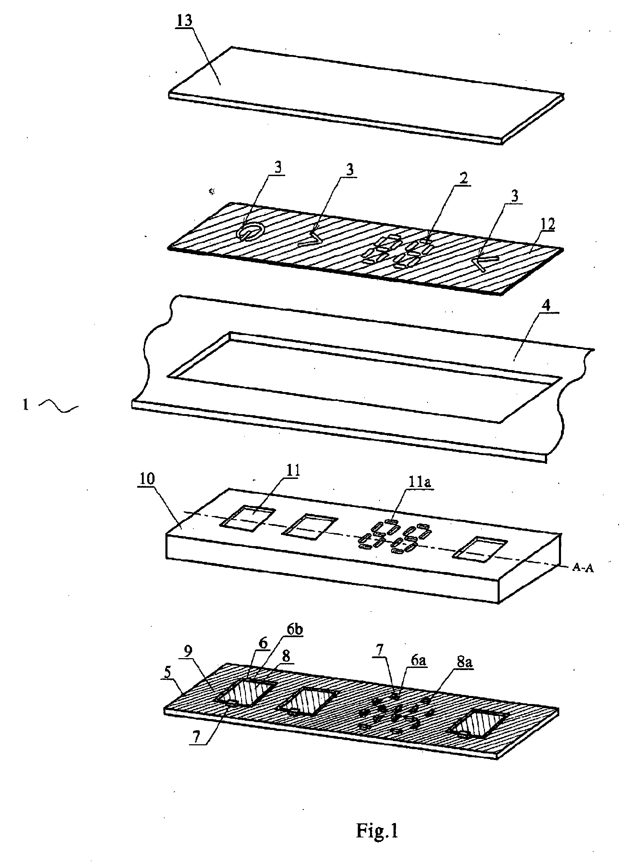

Figure 1: shows a control unit assembly;
Figure 2: shows a cross-section along line A-A of a cavity of an information segment;
Figure 3: shows a cross-section along line A-A of a cavity of a capacitive switch;
Figure 4: shows a plan view of a mesh structure of the electrically conductive surface of the capacitive switch.

A control unit 1 comprising lightning information segments 2 for marking and illuminated capacitive switches 3 is integrated in a front panel 4 of an appliance or apparatus which can be a household appliance, a computer control system, a medical device or any other device or machine controlled by a human.

The basis of the control unit 1 is a printed circuit board 5. Its upper side is provided with fields 6 of capacitive switches 3 which are substantially electrically conductive surfaces 6b, and with fields 6a of the segments 2 of a seven-segment display. Fields 6, 6a are coated with a white protective layer 8, 8a in order to achieve better reflection of the light provided by a side LED 7 arranged at an edge of the fields 6, 6a. All remaining surfaces not falling within the fields 6, 6a are coated with a black protective layer 9 that reduces penetration of the light into individual fields 6, 6a.

Above the printed circuit board 5 there is arranged a support frame 10 of a square form and opened from below in a way that the printed circuit board 5 is substantially inserted into the support frame 10 from the lower side. The upper plane of the frame 10 is provided with openings 11, 11a, the positions of which coincide with respective positions of individual fields 6, 6a on the printed circuit board 5. In said openings 11, 11a there are arranged light guides 14 that provide for an even illumination of capacitive switches 3 or lightning segments 2.

Above the frame 10 a graphic foil 12 is arranged, on which foil individual transparent graphical symbols are arranged, the positions of which coincide with respective positions of the openings 11, 11a for the light guide 14 in the support frame 10 underneath the graphic foil 12 which may be additionally protected by a board 13. A variant without a graphic foil 12 is also possible, wherein the graphical symbols are preferably formed on the lower side of the board 13 by way of printing.

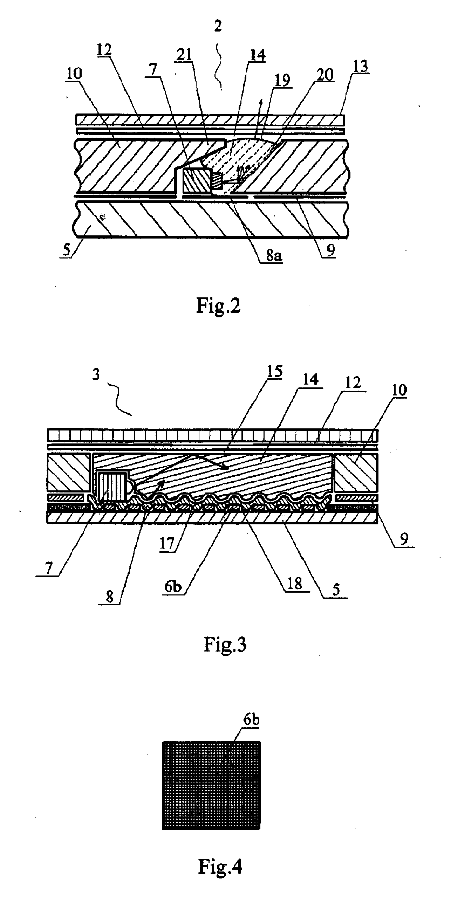

Figure 2 shows a cross-section of the segment 2 of the seven-segment display. Said segment is illuminated by the side LED 7. The LED 7 is arranged on the printed circuit board 5 which forms a bottom limit of a cavity 19 of said segment 2. Said cavity is limited at its upper side by the graphic foil 12. The light of individual segments 2 is separated by means of the support frame 10. At one side the frame limits the cavity 19 by a plane 20, and at the other side the frame is embodied in a way to cover the upper side of the LED 7 by a limiter 21. The cavity 19 may be provided with a lightning guide 14 made of a special heat or UV curable transparent material. This material is poured into individual openings 11a of the support frame 10, said openings simultaneously also representing the openings of the cavities 19 of the segments 2 and coinciding with the arrangement of individual segments on the printed circuit board 5.

Figure 3 shows an illuminated capacitive switch 3 in a cross-section, where the light guide 14 is formed of a special material that is curable by means of temperature of UV light. This material is poured into cavities 15. The bottom of the cavity 15 is coated with the electrically conductive layer 6b of a sensor of the capacitive switch 3, said layer being formed in the shape of a mesh as shown in Figure 4. This layer is covered with the protective layer 8. Said protective layer 8 which is preferably a white colour must have such thickness and viscosity to preserve the configuration of recesses 18 of the electrically conductive layer 6b, which cavities are then filled with a liquid material. Projections 17 of the light guide 14 act as lenses and form an uneven surface and together with the white protective layer 8 of the printed circuit represent a light scattering means (refractor) or a light reflecting means (reflector). The luminous flux emitted by the LED 7 is thus evenly spread in the cavity 15 and evenly illuminates a touch surface of a key from underneath. The black protective layer 9 between the sensors of the switches reduces the light from penetrating into adjacent capacitive switches.

The material used for light guides can be for instance heat curable Protavic PNU46202 or UV curable GE680.

The disclosed invention may be applied for other applications as well, for instance in a stepping switch. Individual capacitive switches can be logically electrically connected into a set for a functional step-wise setting of values.

## Claims

1. A control unit of an appliance comprising lightning information segments (2) for marking and illuminated capacitive switches (3) which can be integrated in a front panel (4) of an appliance or apparatus which can be a household appliance, a computer control system, a medical device or any other device or machine controlled by a human, wherein the control unit of an appliance comprises a printed circuit board (5), on which fields (6) of capacitive switches (3) and fields (6a) of the information segments (2) are arranged, said capacitive switches (3) and said information segments (2) being illuminated by a side LED (7), wherein the fields (6) of the capacitive switches (3) are formed substantially from an electrically conductive layer (6b) of a sensor, wherein a support frame (10) is arranged on the printed circuit board (5), said frame being impermeable to the light emitted by the side LED (7), wherein said support frame (10) is covered with a graphic foil (12), on which both graphical symbols for individual information segments (2) and the capacitive switches (3) are arranged, and on the support frame (10) between the printed circuit board (5) and the graphic foil (12) there are formed cavities (19) of the information segments (2) and cavities (15) of the capacitive switches (3), said cavities (15,19) being filled by a light guide (14), wherein the graphic foil (12) can be protected by a board (13) **characterized in that** the electrically conductive layer (6b) of the sensor of the capacitive switch (3) is formed in the shape of a mesh covered by a protective layer (8) preferably of a white colour and fits to the structure of the mesh, and that on the protective layer (8) the light guide (14) is arranged which fills the cavity (15) and fits the protective layer (8) and thus the mesh-like electrically conductive layer (6b), with which the lower plane of the light guide (14) is formed in the sense of a plurality of lens-like projections (17), whereas the cavity (19) of the segments (2) is formed in a way that side planes (20) are slanted and matted for the light to reflect upwards, and the cavity (19) is at the same time filled with the light guide (14).

2. Control unit of an appliance according to claim 1 **characterized in that** the light guide (14) is made of an artificial material that was previously heat or UV cured.

3. Control unit of an appliance according to claim 1 **characterized in that** individual capacitive switches can be logically electrically connected into a set for a functional step-wise setting of values of the stepping switch.
